# EUROPEAN PATENT SPECIFICATION

(11) **EP 2 953 172 B1**
(45) Date of publication and mention of the grant of the patent: **06.02.2019**
(21) Application number: 14197925.2
(22) Date of filing: 15.12.2014
(51) Int. Cl.: H01L 33/50, F21K 99/00

(54) **Led light source package structure and led light source packaging method**
Gehäusestruktur für LED-Lichtquelle und Verpackungsverfahren für LED-Lichtquelle
Structure de boîtier de source lumineuse à DEL et procédé d'emballage de source de lumière à DEL

(30) Priority: 03.06.2014 CN 201410243610
(43) Date of publication of application: 09.12.2015
(73) Proprietor: Ningbo Sunpu Led Co., Ltd., Hi-Tech Park Ningbo Zhejiang 315040 (CN)
(72) Inventor: Zhang, Riguang, 315040 Ningbo (CN); Lin, Sheng, 315040 Ningbo (CN); Zhang, Yaohua, 315040 Ningbo (CN); Du, Yuanbao, 315040 Ningbo (CN)
(74) Representative: Brevalex

(56) References cited:
- WO-A1-2013/150455
- WO-A2-01/89001
- US-A1- 2010 301 360
- US-A1- 2012 224 363
- US-A1- 2012 250 304

## Description

### FIELD

The present disclosure relates to the technical field of LED packaging, and in particular to a package structure of LED light source and a method for packaging LED light source.

### BACKGROUND

Light-emitting diode (LED) is a kind of p-n junction, which can emit spontaneous-emission light in regions of ultraviolet light, visible light or infrared light. LED light source refers to the light source which utilizes LED as the illuminant. With the development of LED light source, especially the development of the high-brightness LED light source, the packaging technology of LED light source becomes one of the research focuses.

The package for LED light source is an important part of a LED. Like the package for discrete semiconductor elements, it is required that the package of LED light source may prevent a LED chip from being effected by the external environment and may improve the abilities of heat dissipation and conduction. In addition to this, the package of LED light source has special natures. Differing from the package of discrete semiconductor element, the package of LED light source is required to improve light-emission efficiency, realize specific optics profile and output visible light, etc.

The conventional common package of LED light source includes lead package, surface mount package and chip on board (COB) package. In the COB package, a chip is integrated directly to a high thermal conductive material. Compared with the conventional package of LED light source, the COB package is characterized in that multiple LED chips may be packaged directly onto a printed circuit board with a metal or ceramic substrate, and the heat is dissipated directly via the printed circuit board, thereby not only simplifying the manufacturing process of frame and reducing the cost thereof, but also reducing effectively the thermal resistance of device. The LED light source with COB package has good heat dissipation performance and good cost performance, thus it has high market competitiveness.

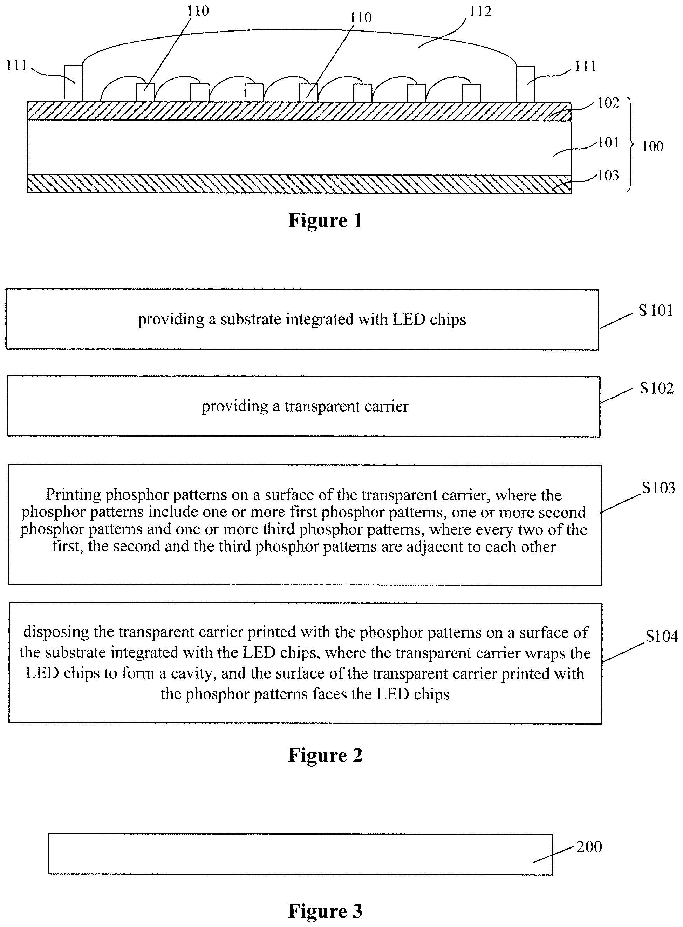

For conventional COB packaging technology of LED light source, reference may be made to Chinese patent with publication No. CN103500787A published on January 8, 2014. The package structure formed by means of the COB packaging technology is shown in Figure 1, including: a substrate 100, where the substrate includes an insulating ceramic substrate 101, a metal circuit layer 102 disposed on a first surface of the insulating ceramic substrate 101, and a metal film electroplated layer 103 disposed on a second surface of the insulating ceramic substrate 101, where the first surface is opposite to the second surface; LED chips 110 on a surface of the substrate 100; a dam 111 around the LED chips on the surface of the substrate 100; and a filling layer 112 filling the dam 111, where the filling layer 112 is doped with phosphors.

However, the package structure formed by means of the conventional COB packaging technology has poor uniformity of light-emission and high cost.

Reference 1 (US2012/250304 A1) discloses an illumination module including a plurality of Light Emitting Diodes (LEDs). A grid structure is present on a transmissive layer over the LEDs, such as an output window, to form a plurality of color conversion pockets. A portion of the pockets are coated with a first type of wavelength converting material while other portions of the pockets are coated with a different type of wavelength converting material.

Reference 2 (WO0189001 A2) discloses a blue-green illumination system, comprising a light emitting diode (11), and at least one luminescent material (21) having at least two peak emission wavelengths, wherein the emission CIE color coordinates of the at least two peak emission wavelengths are located within an area of a pentagon on a CIE chromaticity diagram, whose corners have the following CIE color coordinates: e) x=0.0137 and y=0.4831; b) x=0.2240 and y=0.3890; c) x=0.2800 and y=0.4500; g) x=0.2879 and y=0.5196; and h) x=0.0108 and y=0.7220. The illumination system (51) may be used as the green light of a traffic signal (41). The luminescent material may be a blend of (Ba₁₋ₓEuₓ)Mg₂Al₁₆O₂₇ ("BAM") and (Ba₁₋ₓEuₓ)Mg_{2-y}Mn_{y}Al₁₆O₂₇ ("BAMMn") phosphors, where 0 <x ≤ 0.2 and 0 < y ≤0.5.

Reference 3 (US2010301360 A1) discloses a lighting device including a semiconductor light emitting device (LED) configured to emit light having a first peak wavelength upon the application of a voltage thereto, an element in adjacent, spaced-apart relationship with the LED, and a pattern of discrete lumiphor-containing regions on a surface of, or within, the element. The lumiphor-containing regions are configured to receive light emitted by the LED and convert at least a portion of the received light to light having a longer wavelength than the first peak wavelength. The remote element may be a lens, a reflective element, or a combination thereof.

US 2012/224363 A1 discloses a LED package comprising remote phosphors formed on an hemispherical substrate.

### SUMMARY

It is to provide a method for packaging LED light source and a package structure of LED light source which have good uniformity of light-emission, low cost and high color rendering index.

In view of this, a method for packaging LED light source is provided according to the disclosure, including: providing a substrate integrated with LED chips; providing a transparent carrier; printing phosphor patterns on a surface of the transparent carrier, where the phosphor patterns include one or more first phosphor patterns, one or more second phosphor patterns and one or more third phosphor patterns, where every two of the first, the second and the third phosphor patterns are arranged adjacent to each other; and disposing the transparent carrier printed with the phosphor patterns on a surface of the substrate integrated with the LED chips, where the transparent carrier wraps the LED chips to form a cavity, and the surface, on which the phosphor patterns are printed, of the transparent carrier faces the LED chips. The first, the second and the third phosphor patterns are all regular hexagon-shaped or square shaped, every two of the first, the second and the third phosphor patterns are arranged adjacent to each other, and lines jointing centers of the first, the second and the third phosphor patterns form an equilateral triangle. The transparent carrier is hollow hemisphere-shaped.

Optionally, the first phosphor pattern is red, yellow, green or yellowish green phosphor pattern, the second phosphor pattern is red, yellow, green or yellowish green phosphor pattern, and the third phosphor pattern is red, yellow, green or yellowish green phosphor pattern.

Optionally, the first phosphor pattern is red phosphor pattern, the second phosphor pattern is yellow phosphor pattern, and the third phosphor pattern is green phosphor pattern.

Optionally, the red, yellow and green phosphor patterns are all square-shaped, every two of the red, yellow and green phosphor patterns are arranged adjacent to each other, and lines jointing centers of the red, yellow and the green phosphor patterns form an equilateral triangle.

Optionally, a color temperature and a color rendering index of light-emission are controlled by adjusting thicknesses of the first, the second and the third phosphor patterns.

Optionally, the LED chips are integrated to the substrate by eutectic technology, metal welding or wire-binding.

Optionally, in a case that the LED chips are of a horizontal-structure, the LED chips are integrated to the substrate by means of wire-binding.

Optionally, a metallic bead is formed at a positive terminal of the LED chip with the horizontal-structure and wiring is performed from a negative terminal to the metallic bead at the positive terminal.

Optionally, wiring is performed from a negative terminal of the LED chip with the horizontal-structure to a positive terminal to be connected to the negative terminal, and a metallic bead is planted on a surface of the positive terminal after the wiring.

Optionally, a metallic bead is formed at a positive terminal of the LED chip with the horizontal-structure; wiring is performed from a negative terminal to the metallic bead at the positive terminal; and a metallic bead is planted on a surface of the positive terminal after the wiring.

Optionally, the LED chips are integrated to the substrate by means of eutectic technology in a case that the LED chips are of a flip structure.

Optionally, a connecting wire formed by the wiring has a fishtail-shaped end.

Optionally, the substrate is conductive or non-conductive.

Optionally, the substrate is a ceramic substrate, an aluminum substrate, a glass substrate, a silicon substrate, an aluminum oxide substrate, an aluminum nitride substrate or a copper substrate.

Optionally, the transparent carrier is made of silicone, transparent resin, polycarbonate, or polyvinyl chloride.

A package structure of LED light source is further provided according to the disclosure, including: a substrate integrated with LED chips; a transparent carrier, which is disposed on a surface of the substrate and wraps the LED chips to form a cavity, where a surface of the transparent carrier is printed with phosphor patterns, the phosphor patterns include one or more first phosphor patterns, one or more second phosphor patterns and one or more third phosphor patterns, where every two of the first, the second and the third phosphor patterns are arranged adjacent to each other, and the surface, on which the phosphor patterns are printed, of the transparent carrier faces the LED chips. The first, the second and the third phosphor patterns are all regular hexagon-shaped or square shaped, every two of the first, the second and the third phosphor patterns are arranged adjacent to each other, and lines jointing centers of the first, the second and the third phosphor patterns form an equilateral triangle. The transparent carrier is hollow hemisphere-shaped

Optionally, the first phosphor pattern is red, yellow, green or yellowish green phosphor pattern, the second phosphor pattern is red, yellow, green or yellowish green phosphor pattern, and the third phosphor pattern is red, yellow, green or yellowish green phosphor pattern.

Optionally, the first phosphor pattern is red phosphor pattern, the second phosphor pattern is yellow phosphor pattern, and the third phosphor pattern is green phosphor pattern.

Optionally, the transparent carrier is made of silicone, transparent resin, polycarbonate, or polyvinyl chloride.

Optionally, in a case that the LED chips are integrated to the substrate by means of wire-binding, the package structure of the LED light source further includes a metallic bead disposed at a positive terminal of a first LED chip, and a binding wire connecting a negative terminal of a second LED chip to the metallic bead at the positive terminal of the first LED chip.

Optionally, in a case that the LED chips are integrated to the substrate by means of wire-binding, the package structure of the LED light source further includes a binding wire connecting a positive terminal of a first LED chip to a negative terminal of a second LED chip, and a metallic bead overlaying the binding wire at the positive terminal of the first LED chip.

Optionally, in a case that the LED chips are integrated to the substrate by means of wire-binding, the package structure of the LED light source further includes a metallic bead disposed at a positive terminal of a first LED chip, a binding wire connecting a negative terminal of a second LED chip to the metallic bead at the positive terminal of the first LED chip, and a metallic bead overlaying the binding wire at the positive terminal of the first LED chip.

Compared with the conventional technology, the technical solution of the disclosure has the following advantages.

By the method for packaging LED light source provided according to an embodiment of the disclosure, red, yellow and green phosphor patterns are printed and regularly arranged on a surface of the package structure of the LED light source, the patterns may cover the surface of the package structure to the largest extent, such that the light-emission is uniform and the surface of the package structure is free of dead-zone, thereby improving the light-emission efficiency and the quality of the light source.

Furthermore, in an embodiment of the disclosure, the color temperature and the color rendering indexes of light-emission are controlled by adjusting the thicknesses of the red, yellow and green phosphor patterns, such that the color temperature and color rendering indexes of the LED light source may have high controllability.

Furthermore, in the disclosure, the transparent carrier wraps the LED chips to form a cavity, and the surface, on which the phosphor patterns are printed, of the transparent carrier faces the LED chips, thereby improving the light-emission efficiency of the LED light source. Since the transparent carrier does not contact the LED chips directly and may be replaced easily.

In the package structure of LED light source provided according to an embodiment of the disclosure, red, yellow and green phosphor patterns are printed and regularly arranged on a surface of the package structure of the LED light source, the patterns may cover the surface of the package structure to the largest extent, such that the light-emission is uniform and the surface of the package structure is free of dead-zone, thereby improving the light-emission efficiency and the quality of the light source.

### BRIEF DESCRIPTION OF THE DRAWINGS

Figure 1 is a schematic diagram of a package structure formed by means of COB packaging in the conventional technology;
Figure 2 is a flowchart of a method for packaging LED light source according to an embodiment of the disclosure; and
Figures 3-15 show a process of a method for packaging LED light source according to an embodiment of the disclosure.

### DETAILED DESCRIPTION

It may be learned from the conventional technology that, a package structure formed by means of the conventional COB packaging technology has poor light-emission uniformity and high cost. In addition, the package structure formed by means of the conventional COB packaging technology has poor capability in adjusting color temperature and color rendering index.

In view of these drawbacks, it is founded from an intensive study that, a filling layer doped with phosphors commonly serves to recombine light color. The poor light-emission uniformity of the package structure formed by means of the conventional COB packaging technology is due to the following reasons: taking a white-light light source as an example, phosphors doped into the filling layer is for creating white light via light color recombination; in an example, a LED chip emitting blue light cooperates with yellow phosphors, in which the blue light emitted by the LED chip excites the yellow phosphors to emit yellow light, and then the blue and yellow light are mixed into white light; however, phosphor particles not distributed uniformly in the filling layer result in excited yellow light that is not distributed uniformly, and the phosphor particles which can hardly have uniform sizes also result in excited yellow light that is not uniform, such that the white light mixed by the blue and yellow light is not uniform; it may further be noted that, in the way that the blue light excites the phosphors to emit yellow light and then the blue and the excited yellow light are mixed into white light, it may be difficult to control the uniformity of the white light. Furthermore, affected by long term operation of the LED chip, the transparent filling layer may gradually turn yellow, thereby causing decrease of transparence and affecting light-emission of the LED; and usually, the transparent filling layer is directly adhered to the LED chip, therefore, in a case that the filling layer degenerates, replacement of the filling layer is difficult and is apt to damage the LED chip.

In another example, a LED chip emitting blue light cooperates with red phosphors, yellow phosphors and green phosphors, blue light emitted by the LED chip excites the phosphors to emit red, yellow and green light, and then the excited red, yellow and green light are mixed into white light. However, like the previous example, phosphor particles are not distributed uniformly in the filling layer. In this example, because there are three kinds of phosphors, the phosphors are more difficult to be distributed uniformly, and the particle sizes of the phosphors are difficult to be uniform. In addition, the light may be absorbed by the phosphors due to the multiple kinds of phosphors, such that the mixed white light is difficult to be uniform and the light-emission efficiency is low. Meanwhile, exposed to the blue light emitted by the LED chip for a long time, the transparent filling layer may gradually turn yellow with the long term operation of the LED chip, thereby causing decrease of transparence and affecting light-emission of the LED.

It may be also noted that, the particle size of the phosphor is commonly greater than 10µm, a light scattering may occur on the phosphor surface, therefore the light-emission efficiency is lowered, and an ability of adjusting color temperature and color rendering index is lowered due to the phosphors doped into the filling layer.

Based on the above analysis result, a method for packaging LED light source is provided according to the disclosure. In the method for packaging LED light source, first, second and third regular phosphor patterns are printed on a surface of a transparent carrier in a way that every two of the first, the second and the third phosphor patterns are arranged adjacent to each other, and the transparent carrier is disposed on a substrate integrated with LED chips and a cavity is formed, to cover the surface of the package structure to the largest extent, therefore the uniformity of light-emission is improved, and the surface of the package structure is free of dead-zone, thereby improving the light-emission efficiency and the quality of the light source. The transparent carrier printed with phosphors is used to substitute the transparent filling layer which directly contacts the LED chips, therefore transparence decrease of the filling layer, caused by the fact that the transparent filling layer turns yellow under affection of long term operation of the LED chips, is avoided.

Furthermore, in an embodiment of the disclosure, the color temperature and the color rendering indexes of light are controlled by adjusting the thicknesses of the first, the second and the third phosphor patterns, such that the color temperature and color rendering indexes of the LED light source may have high controllability.

To make the object, features and advantages of the disclosure better understood, the embodiments of the disclosure may be described in detail in conjunction with drawings in the following.

A method for packaging LED light source is provided according to an embodiment of the disclosure. As shown in Figure 2, the method includes steps as follows.

S101 is to provide a substrate integrated with LED chips;

S102 is to provide a transparent carrier;

S103 is to print, on a surface of the transparent carrier, phosphor patterns, where the phosphor patterns include one or more first phosphor patterns, one or more second phosphor patterns and one or more third phosphor patterns, where every two of the first, the second and the third phosphor patterns are arranged adjacent to each other; and

S104 is to dispose the transparent carrier printed with the phosphor patterns on a surface of the substrate integrated with the LED chips, where the transparent carrier wraps the LED chips to form a cavity, and the surface, on which the phosphor patterns are printed, of the transparent carrier faces the LED chips.

As shown in Figure 3, a substrate 200 is provided, where the substrate 200 serves as a carrier for the LED chips and provides a platform for the packaging process. The substrate 200 may be conductive or nonconductive, for example, the substrate 200 may be a ceramic substrate, an aluminum substrate, a glass substrate, a silicon substrate, an aluminum oxide substrate, an aluminum nitride substrate or a copper substrate. For example, the substrate 200 may be a high thermal conductivity aluminum substrate (i.e., a MCPCB), a thick-film ceramic substrate, multilayered low temperature co-fired ceramic substrate, a thin-film ceramic substrate, a silicon substrate, a carborundum substrate, an anodized aluminum substrate or an aluminum nitride substrate. An upper surface and a lower surface of the substrate 200 are provided with at least a circuit structure (not shown in Figure 3). The circuit structure, after being applied with voltage, may drive or assist to drive the LED chips integrated onto the surface of the substrate 200 in the subsequent steps.

The heat dissipation in the package structure of the LED chips usually encounters the bottleneck in heat conduction from the LED chips to the substrate 200 and then to the circuit structure. As an example, a high thermal conductivity aluminum substrate is selected as the substrate 200, and then the heat of the LED chips may be dissipated to the external environment via the high thermal conductivity aluminum substrate, in order to prevent the heat exerting too much influence to the circuit structure.

It may be noted that, those skilled in the art may understand that, the type and size of the substrate 200 may adapt to the actual product, and it is emphasized herein that the scope of the disclosure is not limited thereto. As an example, the substrate 200 may be round, quadrate, pentagonal, hexagonal, etc.

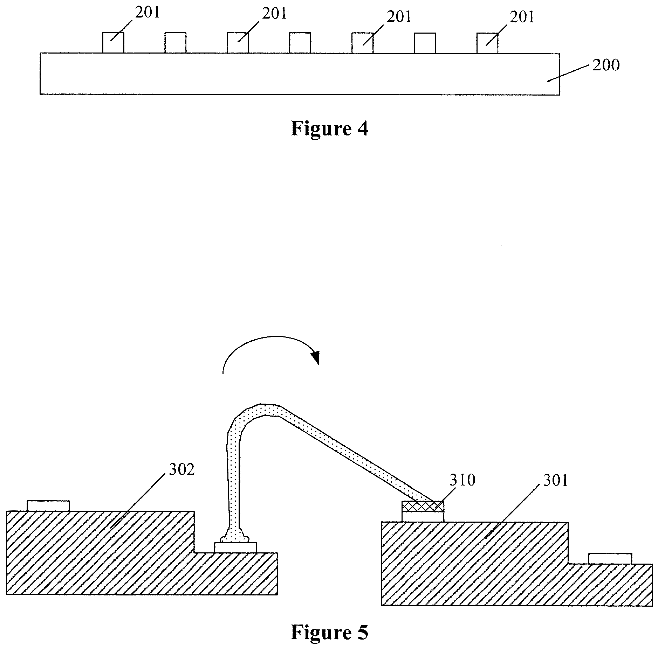

As shown in Figure 4, multiple LED chips 201 are integrated onto the surface of the substrate 200.

The LED chip 201 has a p-n junction formed by process such as pre-injection or doping, and electrons and holes flow from electrodes into the junction under the action of voltage. Once a recombination of a hole and an electron meeting each other in the p-n junction occurs, the electron falls into a lower energy level and releases energy in the form of photons, thereby producing light. The light emitted by the LED chip 201 is applicable in exciting the first, the second and the third phosphor patterns to emit light which may be mixed into white light or light of other colors.

In an embodiment, the LED chip 201 is a blue light LED chip. In other embodiments, the LED chip 201 may be a purple light LED chip. In the embodiment, illustration is made by taking a case that the LED chip 201 is a blue light LED chip as an example, which is not meant to limit the disclosure.

In addition, it may be noted that, the LED chips 201 may be of a horizontal-structure or a flip structure.

The process of integrating the LED chips 201 onto the surface of the substrate 200 may depend on the type of the LED chips 201. For example, the LED chips 201 may be integrated onto the surface of the substrate 200 by eutectic technology, metal welding or wire-binding.

In an embodiment, in a case that the LED chip 201 is of a horizontal-structure, heat-conducting epoxy resin, conductive paste or conductive silver paste are coated on pre-placed points for the LED chips on the substrate 200, and the horizontal-structure LED chips are adhered to the pre-placed points, and then a heat-treatment processing may be performed to increase the adhesive strength between the LED chips 201 and the substrate 200. After being adhered to the substrate 200, the LED chips 201 are interconnected to each other or connected to the predisposed circuit structure of the substrate 200 by means of wire-bonding.

It may be noted that, in a case that a negative terminal of a first LED chip is connected to a positive terminal of a second LED chip, the circuit interconnection is weak and a circuit malfunction may resulted from the connection. To improve the circuit interconnection formed by means of wire-bonding and avoid the circuit malfunction, referring to Figure 5, in the embodiment, for electrically connecting a first LED chip 301 with horizontal-structure to a second LED chip 302 with horizontal-structure, a metallic bead 310 is formed at a positive terminal of the first LED chip 301 with horizontal-structure, and then wiring is performed from a negative terminal of the second LED chip 302 with horizontal-structure to the metallic bead at the positive terminal of the first LED chip 301 with horizontal-structure. The metallic bead 310 may avoid welding pads at the positive and negative terminals of the horizontal-structure LED chips from being detached due to a change of tension of the connecting wires in the process of wiring.

The positive and negative terminals of the horizontal-structure LED chip are both on a top surface of the LED chip, and the negative terminal is exposed by removing part of the positive terminal and the internal structure of the LED chip. The positive and negative terminals are in a step-like shape, and the exposed area of the negative terminal is much smaller than the area of the positive terminal. To avoid the circuit malfunction occurring in a case that the connecting wire contacts a side wall of the step in the process of wiring, the wiring may be performed in the direction from the negative terminal of the second LED chip 302 with horizontal-structure to the positive terminal of the first LED chip 301 with horizontal-structure.

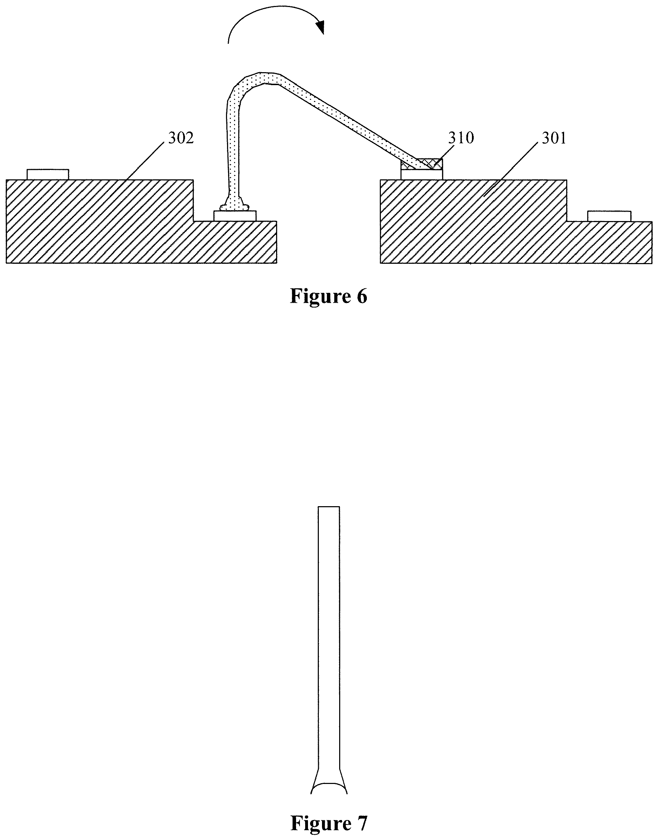

In another embodiment, as shown in Figure 6, in a case that the first LED chip 301 with horizontal-structure is to be connected electrically to the second LED chip 302 with horizontal-structure, wiring is performed from the negative terminal of the second LED chip 302 with horizontal-structure to the positive terminal of the first LED chip 301 with horizontal-structure, and then a metallic bead 310 is planted on the surface of the positive terminal of the first LED chip 301 with horizontal-structure to strength a binding force between the connecting wire and the welding pads at the positive and negative terminals.

In another embodiment, in a case that the first LED chip with horizontal-structure is to be connected electrically to the second LED chip with horizontal-structure, a metallic bead is formed at the positive terminal of the first LED chip with horizontal-structure, and wiring is performed from the negative terminal of the second LED chip with horizontal-structure to the positive terminal of the first LED chip with horizontal-structure, and subsequently a metallic bead is planted on the surface of the positive terminal of the first LED chip with horizontal-structure, thereby reducing difficulty in wiring from the negative terminal of the second LED chip with horizontal-structure to the metallic bead at the positive terminal of the first LED chip with horizontal-structure and strengthening the circuit interconnection formed by means of wire-binding.

To make the embodiment better understood, Figure 7 shows the connecting wire formed in the process of wiring from the negative terminal of the second LED chip 302 with horizontal-structure to the positive terminal of the first LED chip 301 with horizontal-structure and planting a metallic bead 310 at the positive terminal of the first LED chip 301 with horizontal-structure. As shown in Figure 7, an end of the connecting wire is like a fishtail due to presence of the metallic bead 310, and the fishtail-like connecting wire may strengthen a binding force between the connecting wire and the welding pads at the positive and negative terminals of the horizontal-structure LED chips.

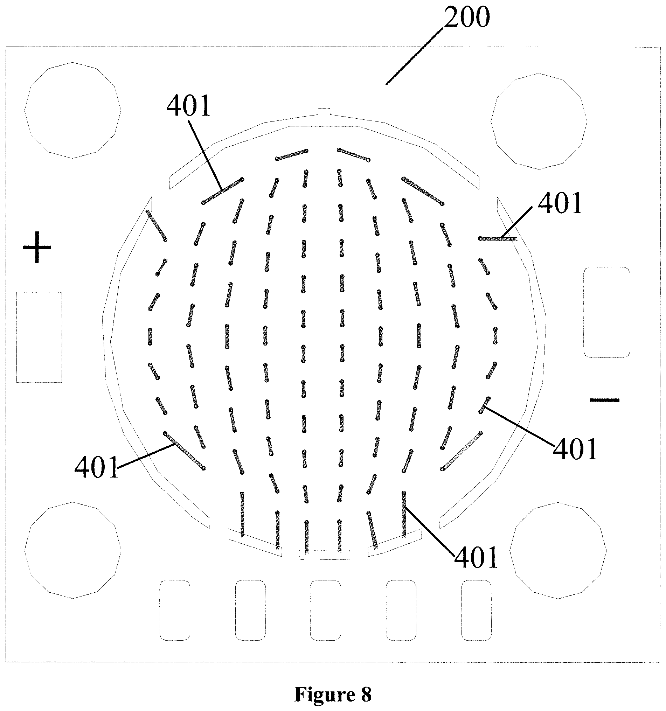

In another embodiment, in a case that the LED chip 201 is of a flip structure in which a light-emission area faces an electrode area, as shown in Figure 8, predetermined eutectic lines 401 are formed on the surface of the substrate 200, where the eutectic lines may be formed by means of physical vapor deposition. The predetermined eutectic lines 401 are to be connected to the LED chips 201 to be integrated subsequently.

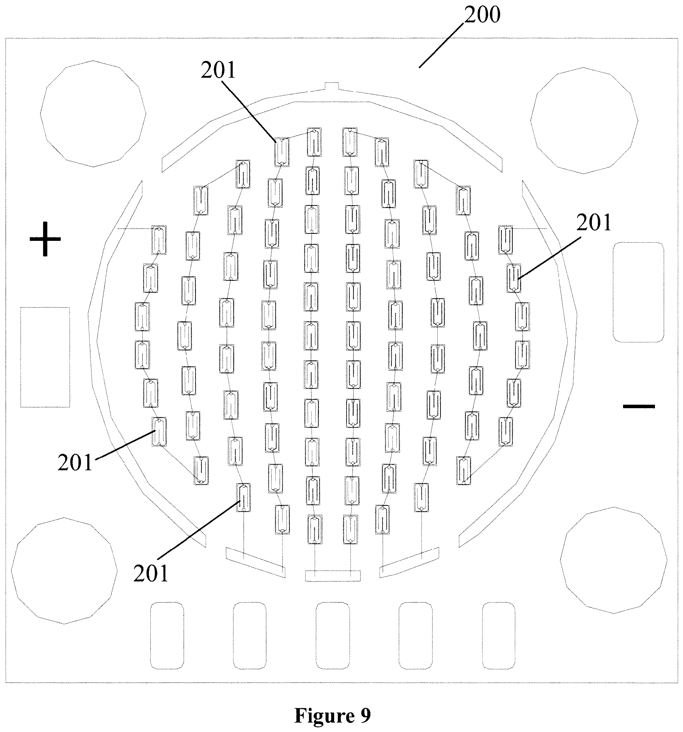

As shown in Figure 9, the LED chips 201 are formed correspondingly on the eutectic lines by means of eutectic technology.

As an example, to connect a positive terminal of a first LED chip to a negative terminal of a second LED chip, the positive terminal of the first LED is connected to one end of a eutectic line in eutectic manner, and the negative terminal of the second LED chip is connected to the other end of the eutectic line in eutectic manner; the one or more LED chips 201 are integrated onto the surface of the substrate 200 one by one.

After the LED chips 201 are integrated onto the surface of the substrate 200, in the conventional technology, usually phosphors are doped into a transparent substance such as silicone, transparent resin, polycarbonate or polyvinyl chloride, etc, and the transparent substance doped with the phosphors forms a filling layer covering the LED chips 201.

From the foregoing analysis, it is can be seen that a conventional package structure has poor uniformity of light-emission, and transparence of the filling layer decreases after a long time operation, thereby affecting device performance.

By contrast, according to the embodiment of the disclosure, a transparent carrier is disposed on a substrate integrated with LED chips to form a cavity, substituting a conventional way in which a filling layer directly covers the LED chips, and phosphor patterns are printed on a surface of the transparent carrier, which faces the LED chips, thereby improving light-emission uniformity.

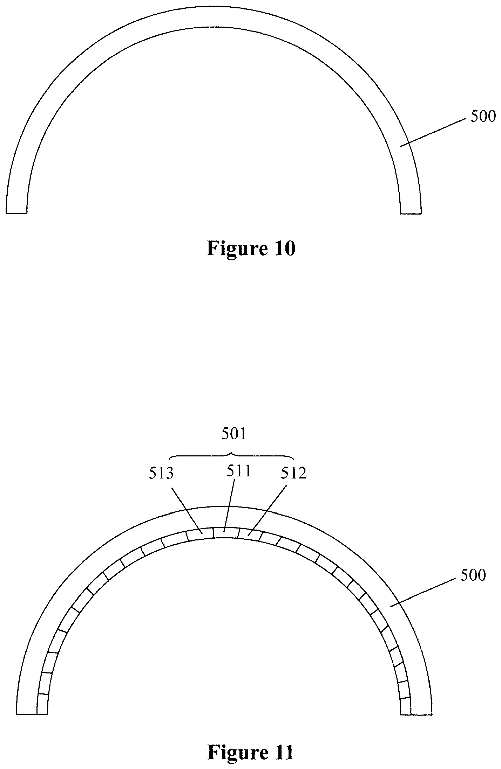

Referring to Figure 10, a transparent carrier 500 is provided.

The transparent carrier 500 is configured to wrap the LED chips 201 to form a cavity subsequently, and the transparent carrier 500 is made of silicone, transparent resin, polycarbonate or polyvinyl chloride.

Referring to Figure 11, a surface of the transparent carrier 500 is printed with phosphor patterns 501, including one or more first phosphor patterns 511, one or more second phosphor patterns 512 and one or more third phosphor patterns 513, where every two of the first, the second and the third phosphor patterns are arranged adjacent to each other.

The phosphor patterns 501 includes one or more first phosphor patterns 511, one or more second phosphor patterns 512 and one or more third phosphor patterns 513, where every two of the first, the second and the third phosphor patterns are arranged adjacent to each other, and lines jointing centers of the first phosphor pattern 511, the second phosphor patterns 512 and the third phosphor pattern 513 form an equilateral triangle.

As an embodiment, the first phosphor patterns 511 are red, yellow, green or yellowish green phosphor patterns. The second phosphor patterns 512 are red, yellow, green or yellowish green phosphor patterns. The third phosphor patterns are 513 red, yellow, green or yellowish green phosphor patterns.

As another embodiment, the first phosphor patterns 511 are red phosphor patterns, the second phosphor patterns 512 are yellow phosphor patterns, and the third phosphor patterns 513 are green phosphor patterns.

In the embodiment, every two of the red, yellow and green phosphor patterns are arranged adjacent to each other, such that the red, yellow and green phosphor patterns in the phosphor patterns 501 may be distributed uniformly, such that the LED chip 201 may excite more efficiently the phosphors in the red, yellow and green phosphor patterns, and the red light emitted by exciting the red phosphor pattern, the yellow light emitted by exciting the yellow phosphor pattern and the green light emitted by exciting the green phosphor pattern may be distributed uniformly, and the emission of the mixed white light may be more uniform.

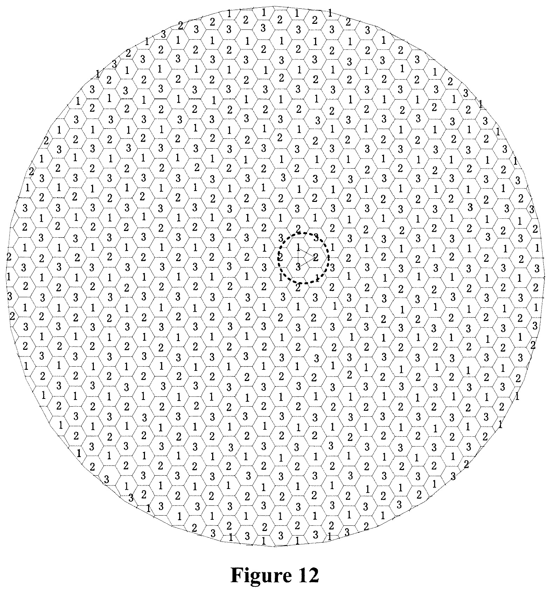

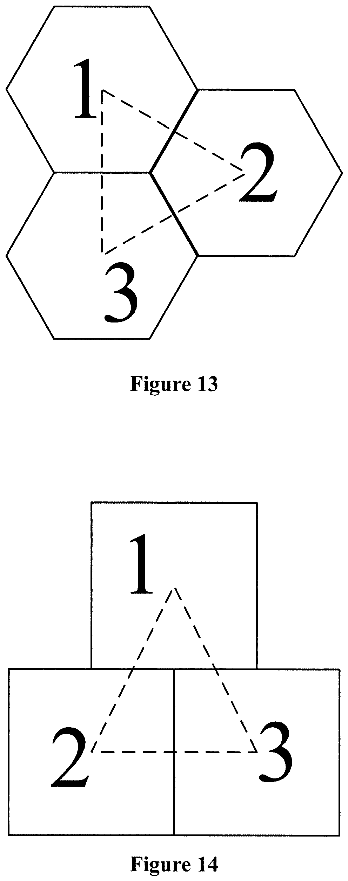

Furthermore, referring to Figure 12 and Figure 13, Figure 12 is a schematic diagram of phosphor patterns provided according to another embodiment of the disclosure, and Figure 13 is an enlarged partial diagram for a part of the phosphor patterns which is marked by a dashed-line circle in Figure 12. In the embodiment, red phosphor patterns 1, yellow phosphor patterns 2 and green phosphor patterns 3 are all regular hexagon-shaped, and every two of the red phosphor patterns 1, the yellow phosphor patterns 2 and the green phosphor patterns 3 are arranged adjacent to each other.

In the embodiment, the red phosphor pattern 1, the yellow phosphor pattern 2 and the green phosphor pattern 3 are selected to be all regular hexagon-shaped, such that every two of the red phosphor patterns 1, the yellow phosphor patterns 2 and the green phosphor patterns 3 may be adjacent to each other without gaps, thereby the emission of the mixed white light may be more uniform. As shown in Figure 12 and Figure 13, lines jointing centers of the red phosphor pattern 1, the yellow phosphor pattern 2 and the green phosphor pattern 3 form an equilateral triangle, such that the red phosphor patterns 1, the yellow phosphor patterns 2 and the green phosphor patterns 3 may be arranged as closely as possible and arranged uniformly on the surface of the transparent carrier, thereby the light-emission of the mixed white light may be more uniform.

In another embodiment, as shown in Figure 14, the red phosphor patterns 1, the yellow phosphor patterns 2 and the green phosphor patterns 3 are all square-shaped. The square-shaped patterns may fill the transparent carrier 500 to the largest extent, i.e., lines jointing centers of the red phosphor pattern 1, the yellow phosphor pattern 2 and the green phosphor pattern 3 form an equilateral triangle, therefore LED chips may excite the phosphors more efficiently.

In another embodiment, the color temperature and color rendering indexes of light-emission may be controlled by adjusting the thicknesses of the first, the second and the third phosphor patterns.

The color temperature and color rendering indexes of light-emission are controlled by adjusting the thicknesses of the red phosphor patterns 1, the yellow phosphor patterns 2 and the green phosphor patterns 3, such that the color temperature and color rendering indexes of the LED light source may have high controllability.

It is should be noted that the shape of the transparent carrier 500 may be configured in advance according to the shape of the substrate integrated with the LED chips. Referring to Figure 11, the transparent carrier is configured to be a hollow hemispheric transparent carrier 500, and the phosphor patterns 501 are printed on the inner wall of the hemispheric transparent carrier 500.

In other embodiments not part of the invention, the phosphor patterns 501 may be printed on a sheet-shaped or film-shaped transparent carrier 500 in advance, and the sheet-shaped or film-shaped transparent carrier 500 is processed into an inwardly concaved transparent carrier 500.

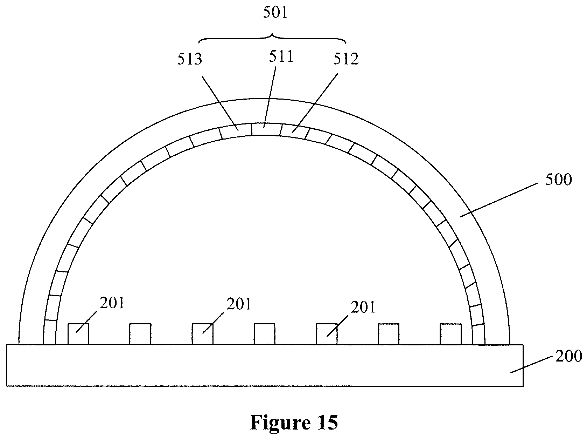

Referring to Figure 15, the transparent carrier 500 printed with phosphor patterns is disposed on a surface of a substrate 200 integrated with LED chips. The transparent carrier 500 wraps the LED chips 201 to form a cavity, and a surface, on which the phosphor patterns 501 are printed, of the transparent carrier 500 faces the LED chips 201.

Illustration is made of the the hemispheric transparent carrier 500. The surface of substrate 200 is provided with a slot surrounding the LED chips 201, the edge of the hemispheric transparent carrier 500 is provided with a fastener for fastening the hemispheric transparent carrier 500 into the slot on the surface of the substrate 200, such that the hemispheric transparent carrier 500 wraps the LED chips 201 to form a cavity, and the surface, on which the phosphor patterns 501 are printed, of the transparent carrier 500 faces the LED chips 201.

In other embodiments, the transparent carrier 500 may be disposed on the surface of the substrate 200 integrated with the LED chips by means of adhesion or other means of attachment. Those skilled in the art should understand that the means of disposing the transparent carrier 500 on the surface of the substrate 200 integrated with the LED chips may be used as long as the transparent carrier 500 may be stably disposed on the surface of the substrate 200 integrated with the LED chips, and it is noted herein that the scope of the disclosure should not be limited thereto.

Furthermore, the cavity may be evacuated in subsequent steps.

In the embodiment, the transparent carrier 500 printed with the phosphor patterns 501 wraps the LED chips 201 to form a cavity, substituting a conventional way in which a filling layer directly covers the LED chips 201, therefore, decrease of light-emission efficiency of the LED chips, caused by the degeneration of the filling layer after a long time operation, is avoided. The transparent carrier 500 wraps the LED chips 201 to form a cavity, therefore there is cavity between the transparent carrier 500 and the LED chips, and the transparent carrier 500 does not directly contact the LED chips 201, thus subsequent replacement of the transparent carrier 500 is more convenient, and maintenance cost is low.

Furthermore, the transparent carrier 500 printed with the phosphor patterns 501 is in the shape of a hollow hemisphere. When the hollow hemispheric transparent carrier is disposed on the surface of the substrate 200 integrated with the LED chips, the hollow hemispheric transparent carrier forms a lens with respect to the LED chips, effectively avoiding total reflection incurred by the case that light excited by the LED enters from the cavity (optically thinner medium) into the transparent carrier 500 (optically denser medium), thereby improving light-emission efficiency of the LED package structure.

A package structure of LED light source is further provided according to an embodiment of the disclosure. As shown in Figure 15, the package structure includes:
a substrate 200 integrated with LED chips 201;
a transparent carrier 500 disposed on a surface of the substrate 200, where the transparent carrier 500 wraps the LED chips 201 to form a cavity, and a surface of the transparent carrier 500 is printed with phosphor patterns 501, the phosphor patterns 501 include: one or more first phosphor patterns 511, one or more second phosphor patterns 512 and one or more third phosphor patterns 513, where every two of the first, second, and third phosphor patterns 511, 512 and 513 are arranged adjacent to each other., and the surface, on which the phosphor patterns 501 are printed, of the transparent carrier 500 faces the LED chips 201.

The transparent carrier 500 is hollow hemisphere-shaped. In an embodiment, the transparent carrier 500 is disposed on the surface of the substrate 200 to form a lens. The transparent carrier 500 is an optically denser medium relative to the cavity, and the cavity is an optically thinner medium relative to the transparent carrier 500, and total reflection may occur for light incident from the optically thinner medium to the optically denser medium. By means of the lens formed by disposing the transparent carrier 500 on the surface of the substrate 200, total reflection incurred by the case that light excited by the LED chips enters from the optically thinner medium into the optically denser medium may be avoided efficiently, thereby improving light-emission efficiency of the LED package structure.

The transparent carrier 500 may be disposed on the surface of the substrate 200 by means of fastener or adhesion without contacting the LED chips 201, therefore replacement of the transparent carrier 500 is convenient.

In the embodiment, first, second and third phosphor patterns are printed and regularly arranged on a surface of the package structure of the LED light source, the patterns may cover the surface of the package structure to the largest extent, such that the light-emission is uniform and the surface of the package structure is free of dead-zone, thereby improving light-emission efficiency and a quality of the light source.

As an embodiment, the first phosphor pattern is red, yellow, green or yellowish green, the second phosphor pattern is red, yellow, green or yellowish green, and the third phosphor pattern is red, yellow, green or yellowish green.
As another embodiment, the first phosphor pattern is red, the second phosphor pattern is yellow, and the third phosphor pattern is green.

The LED chip 201 may be integrated onto the substrate 200 by means of wire-binding or eutectic technology.

In a case that the LED chips 201 are integrated onto the surface of the substrate 200 by means of wire-binding, the package structure of the LED light source further includes a metallic bead disposed at a positive terminal of a first LED chip, and a binding wire connecting a negative terminal of a second LED chip to the metallic bead at the positive terminal of the first LED chip. The first and the second LED chips are any two of the LED chips 201 to be connected electrically.

In another embodiment, in a case that the LED chips 201 are integrated onto the surface of the substrate 200 by means of wire-binding, the package structure of the LED light source further includes a binding wire connecting the positive terminal of the first LED chip to the negative terminal of the second LED chip, and a metallic bead overlaying the binding wire at the positive terminal of the first LED chip.

In another embodiment, in a case that the LED chips 201 are integrated onto the surface of the substrate 200 by means of wire-binding, the package structure of the LED light source further includes a metallic bead at the positive terminal of the first LED chip, a binding wire connecting the negative terminal of the second LED chip and the metallic bead at the positive terminal of the first LED chip, and another metallic bead overlaying the binding wire at the positive terminal of the first LED chip.
The embodiments of the disclosure are disclosed in the foregoing description, but there are not meant to limit the disclosure. The invention is defined by the appended claims.

## Claims

1. A method for packaging LED light source, comprising:
providing a substrate (200) integrated with LED chips (201);
providing a transparent carrier (500) which is hollow hemisphere shaped;
printing phosphor patterns (501) on a surface of the transparent carrier (500), wherein the phosphor patterns (501) comprise one or more first phosphor patterns (511), one or more second phosphor patterns (512) and one or more third phosphor patterns (513); and
disposing the transparent carrier (500) printed with the phosphor patterns (501) on a surface of the substrate integrated with the LED chips, wherein the transparent carrier (500) wraps the LED chips (201) to form a cavity, and the surface, on which the phosphor patterns (501) are printed, of the transparent carrier (500) faces the LED chips (201),
**characterized in that**:
the first, the second and the third phosphor patterns are all regular hexagon-shaped or square shaped, every two of the first, the second and the third phosphor patterns are arranged adjacent to each other, and lines jointing centers of the first, the second and the third phosphor patterns form an equilateral triangle.

2. The method for packaging LED light source according to claim 1, wherein the first phosphor pattern (511) is red, yellow, green or yellowish green phosphor pattern, the second phosphor pattern (512) is red, yellow, green or yellowish green phosphor pattern, and the third phosphor pattern (513) is red, yellow, green or yellowish green phosphor pattern.

3. The method for packaging LED light source according to claim 1, wherein a color temperature and a color rendering index of light-emission are controlled by adjusting thicknesses of the first, the second and the third phosphor patterns.

4. The method for packaging LED light source according to claim 1, wherein the LED chips (201) are integrated to the substrate (200) by eutectic technology, metal welding or wire-binding.

5. The method for packaging LED light source according to claim 4, wherein in a case that the LED chips (201) are of a horizontal-structure, the LED chips are integrated to the substrate by means of wire-binding.

6. The method for packaging LED light source according to claim 5, wherein the method comprises forming a metallic bead at a positive terminal of the LED chip (201) with the horizontal-structure; and wiring from a negative terminal to the metallic bead at the positive terminal.

7. The method for packaging LED light source according to claim 5, wherein the method comprises wiring from a negative terminal of the LED chip (201) with the horizontal-structure to a positive terminal to be connected to the negative terminal; and planting a metallic bead on a surface of the positive terminal after the wiring.

8. The method for packaging LED light source according to claim 5, wherein the method comprises forming a metallic bead at a positive terminal of the LED chip (201) with the horizontal-structure; wiring from a negative terminal to the metallic bead at the positive terminal; and planting a metallic bead on a surface of the positive terminal after the wiring.

9. The method for packaging LED light source according to claim 4, wherein the LED chips are integrated to the substrate by means of eutectic technology in a case that the LED chips are of a flip structure.

10. The method for packaging LED light source according to claim 7, wherein a connecting wire formed by the wiring has a fishtail-shaped end.

11. A package structure of LED light source, comprising:
a substrate (200) integrated with LED chips (201);
a transparent carrier (500) which is hollow hemisphere shaped disposed on a surface of the substrate (200), wherein the transparent carrier (500) wraps the LED chips (201) to form a cavity, and a surface of the transparent carrier (500) is printed with phosphor patterns (501), the phosphor patterns comprise one or more first phosphor patterns (511), one or more second phosphor pattern (512) and one or more third phosphor patterns (513), wherein the surface, on which the phosphor patterns (501) are printed, of the transparent carrier (500) faces the LED chips (201),
**characterized in that**:
the first, the second and the third phosphor patterns are all regular hexagon-shaped or square shaped, every two of the first, the second and the third phosphor patterns are arranged adjacent to each other, and lines jointing centers of the first, the second and the third phosphor patterns form an equilateral triangle.

12. The package structure of LED light source according to claim 11, wherein the first phosphor pattern (511) is red, yellow, green or yellowish green phosphor pattern, the second phosphor pattern (512) is red, yellow, green or yellowish green phosphor pattern, and the third phosphor pattern (513) is red, yellow, green or yellowish green phosphor pattern.

13. The package structure of LED light source according to claim 11, wherein in a case that the LED chips are integrated to the substrate by means of wire-binding, the package structure of the LED light source further comprises a metallic bead disposed at a positive terminal of a first LED chip, and a binding wire connecting a negative terminal of a second LED chip to the metallic bead at the positive terminal of the first LED chip.

14. The package structure of LED light source according to claim 11, wherein in a case that the LED chips (201) are integrated to the substrate (200) by means of wire-binding, the package structure of the LED light source further comprises a binding wire connecting a positive terminal of a first LED chip (301) to a negative terminal of a second LED chip (302), and a metallic bead overlaying the binding wire at the positive terminal of the first LED chip (301).

15. The package structure of LED light source according to claim 11, wherein in a case that the LED chips (201) are integrated to the substrate (200) by means of wire-binding, the package structure of the LED light source further comprises a metallic bead disposed at a positive terminal of a first LED chip (301), a binding wire connecting a negative terminal of a second LED chip (302) to the metallic bead at the positive terminal of the first LED chip (301), and a metallic bead overlaying the binding wire at the positive terminal of the first LED chip (301).

## Patentansprüche

1. Verfahren zum Verpacken einer LED-Lichtquelle, umfassend:
Bereitstellen eines Substrats (200), das mit LED-Chips (201) integriert ist;
Bereitstellen eines transparenten Trägers (500), der hohl-halbkugelförmig ist;
Drucken von Leuchtstoffmustern (501) auf eine Oberfläche des transparenten Trägers (500), wobei die Leuchtstoffmuster (501) ein oder mehr erste Leuchtstoffmuster (511), ein oder mehr zweite Leuchtstoffmuster (512) und ein oder mehr dritte Leuchtstoffmuster (513) umfassen; und
Anordnen des mit den Leuchtstoffmustern (501) bedruckten transparenten Trägers (500) auf einer Oberfläche des mit den LED-Chips integrierten Substrats, wobei der transparente Träger (500) die LED-Chips (201) umhüllt, um einen Hohlraum zu bilden, und wobei die Oberfläche des transparenten Trägers (500), auf die die Leuchtstoffmuster (501) gedruckt sind, den LED-Chips (201) gegenüber liegt,
**dadurch gekennzeichnet, dass**:
die ersten, die zweiten und die dritten Leuchtstoffmuster alle gleichmäßig sechseckförmig oder quadratförmig sind, wobei jeweils zwei von den ersten, den zweiten und den dritten Leuchtstoffmustern einander benachbart angeordnet sind, und wobei Linien, die Zentren der ersten, der zweiten und der dritten Leuchtstoffmuster verbinden, ein gleichseitiges Dreieck bilden.

2. Verfahren zum Verpacken einer LED-Lichtquelle nach Anspruch 1, wobei das erste Leuchtstoffmuster (511) ein rotes, gelbes, grünes oder gelblich grünes Leuchtstoffmuster ist, wobei das zweite Leuchtstoffmuster (512) ein rotes, gelbes, grünes oder gelblich grünes Leuchtstoffmuster ist, und wobei das dritte Leuchtstoffmuster (513) ein rotes, gelbes, grünes oder gelblich grünes Leuchtstoffmuster ist.

3. Verfahren zum Verpacken einer LED-Lichtquelle nach Anspruch 1, wobei eine Farbtemperatur und ein Farbrenderingindex der Lichtemission durch Einstellen von Dicken der ersten, der zweiten und der dritten Leuchtstoffmuster gesteuert werden.

4. Verfahren zum Verpacken einer LED-Lichtquelle nach Anspruch 1, wobei die LED-Chips (201) mit dem Substrat (200) durch Eutektiktechnologie, Metallschweißen oder Drahtbonden integriert werden.

5. Verfahren zum Verpacken einer LED-Lichtquelle nach Anspruch 4, wobei in einem Fall, in dem die LED-Chips (201) eine horizontale Struktur haben, die LED-Chips mit dem Substrat mittels Drahtbonden integriert werden.

6. Verfahren zum Verpacken einer LED-Lichtquelle nach Anspruch 5, wobei das Verfahren das Bilden eines Metallpunkts an einem positiven Terminal des LED-Chips (201) mit der horizontalen Struktur umfasst, und ein Verdrahten von einem negativen Terminal zu dem Metallpunkt an dem positiven Terminal.

7. Verfahren zum Verpacken einer LED-Lichtquelle nach Anspruch 5, wobei das Verfahren ein Verdrahten von einem negativen Terminal des LED-Chips (201) mit der horizontalen Struktur zu einem positiven Terminal umfasst, das mit dem negativen Terminal verbunden werden soll, und ein Aufbringen eines Metallpunkts auf einer Oberfläche des positiven Terminals nach der Verdrahtung.

8. Verfahren zum Verpacken einer LED-Lichtquelle nach Anspruch 5, wobei das Verfahren ein Bilden eines Metallpunkts an einem positiven Terminal des LED-Chips (201) mit der horizontalen Struktur umfasst, ein Verdrahten von einem negativen Terminal zu dem Metallpunkt an dem positiven Terminal, und ein Aufbringen eines Metallpunkts auf einer Oberfläche des positiven Terminals nach der Verdrahtung.

9. Verfahren zum Verpacken einer LED-Lichtquelle nach Anspruch 4, wobei die LED-Chips mit dem Substrat mittels Eutektiktechnologie in einem Fall integriert werden, in dem die LED-Chips eine Flipstruktur haben.

10. Verfahren zum Verpacken einer LED-Lichtquelle nach Anspruch 7, wobei ein Verbindungsdraht, der durch die Verdrahtung gebildet ist, ein fischschwanzförmiges Ende hat.

11. Verpackungsstruktur einer LED-Lichtquelle, umfassend:
ein Substrat (200), das mit LED-Chips (201) integriert ist;
einen transparenten Trägers (500), der hohl-halbkugelförmig ist und auf einer Oberfläche des Substrats (200) angeordnet ist, wobei der transparente Träger (500) die LED-Chips (201) umhüllt, um einen Hohlraum zu bilden, und wobei eine Oberfläche des transparenten Trägers (500) mit Leuchtstoffmustern (501) bedruckt ist, wobei die Leuchtstoffmuster ein oder mehr erste Leuchtstoffmuster (511), ein oder mehr zweite Leuchtstoffmuster (512) und ein oder mehr dritte Leuchtstoffmuster (513) umfassen, wobei die Oberfläche des transparenten Trägers (500), auf die die Leuchtstoffmuster (501) gedruckt sind, den LED-Chips (201) gegenüber liegt,
**dadurch gekennzeichnet, dass**:
die ersten, die zweiten und die dritten Leuchtstoffmuster alle gleichmäßig sechseckförmig oder quadratförmig sind, wobei jeweils zwei von den ersten, den zweiten und den dritten Leuchtstoffmustern einander benachbart angeordnet sind, und wobei Linien, die Zentren der ersten, der zweiten und der dritten Leuchtstoffmuster verbinden, ein gleichseitiges Dreieck bilden.

12. Verpackungsstruktur einer LED-Lichtquelle nach Anspruch 11, wobei das erste Leuchtstoffmuster (511) ein rotes, gelbes, grünes oder gelblich grünes Leuchtstoffmuster ist, wobei das zweite Leuchtstoffmuster (512) ein rotes, gelbes, grünes oder gelblich grünes Leuchtstoffmuster ist, und wobei das dritte Leuchtstoffmuster (513) ein rotes, gelbes, grünes oder gelblich grünes Leuchtstoffmuster ist.

13. Verpackungsstruktur einer LED-Lichtquelle nach Anspruch 11, wobei in einem Fall, in dem die LED-Chips mit dem Substrat durch Drahtbonden integriert sind, die Verpackungsstruktur der LED-Lichtquelle ferner einen Metallpunkt umfasst, der an einem positiven Terminal eines ersten LED-Chips angeordnet ist, und einen Verbindungsdraht, der ein negatives Terminal eines zweiten LED-Chips mit dem Metallpunkt an dem positiven Terminal des ersten LED-Chips verbindet.

14. Verpackungsstruktur einer LED-Lichtquelle nach Anspruch 11, wobei in einem Fall, in dem die LED-Chips (201) mit dem Substrat (200) durch Drahtbonden integriert sind, die Verpackungsstruktur der LED-Lichtquelle ferner einen Verbindungsdraht umfasst, der ein positives Terminal eines ersten LED-Chips (301) mit einem negativen Terminal eines zweiten LED-Chips (302) verbindet, und wobei ein Metallpunkt den Verbindungsdraht an dem positiven Terminal des ersten LED-Chips (301) überlagert.

15. Verpackungsstruktur einer LED-Lichtquelle nach Anspruch 11, wobei in einem Fall, in dem die LED-Chips (201) mit dem Substrat (200) durch Drahtbonden integriert sind, die Verpackungsstruktur der LED-Lichtquelle ferner einen Metallpunkt umfasst, der an einem positiven Terminal eines ersten LED-Chips (301) angeordnet ist, einen Verbindungsdraht, der ein negatives Terminal eines zweiten LED-Chips (302) mit dem Metallpunkt an dem positiven Terminal des ersten LED-Chips (301) verbindet, und einen Metallpunkt, der den Verbindungsdraht an dem positiven Terminal des ersten LED-Chips (301) überlagert.

## Revendications

1. Procédé d'encapsulation d'une source de lumière de DEL, comprenant :
la fourniture d'un substrat (200) intégré avec des puces de DEL (201) ;
la fourniture d'un porteur transparent (500) qui est en forme d'hémisphère creux ;
l'impression de motifs de phosphore (501) sur une surface du porteur transparent (500), dans lequel les motifs de phosphore (501) comprennent un ou plusieurs premiers motifs de phosphore (511), un ou plusieurs deuxièmes motifs de phosphore (512) et un ou plusieurs troisièmes motifs de phosphore (513) ; et
la disposition du porteur transparent (500) imprimé avec les motifs de phosphore (501) sur une surface du substrat intégré avec les puces de DEL, dans lequel le porteur transparent (500) enveloppe les puces de DEL (201) pour former une cavité, et la surface, sur laquelle sont imprimés les motifs de phosphore (501), du porteur transparent (500) fait face aux puces de DEL (201),
**caractérisé en ce que** :
les premiers, les deuxièmes et les troisièmes motifs de phosphore sont tous en forme d'hexagone régulier ou en forme de carré, deux quelconques des premiers, des deuxièmes et des troisièmes motifs de phosphore sont agencés adjacents l'un à l'autre, et des droites reliant des centres des premiers, des deuxièmes et des troisièmes motifs de phosphore forment un triangle équilatéral.

2. Procédé d'encapsulation d'une source de lumière de DEL selon la revendication 1, dans lequel le premier motif de phosphore (511) est un motif de phosphore rouge, jaune, vert ou vert jaunâtre, le deuxième motif de phosphore (512) est un motif de phosphore rouge, jaune, vert ou vert jaunâtre, et le troisième motif de phosphore (513) est un motif de phosphore rouge, jaune, vert ou vert jaunâtre.

3. Procédé d'encapsulation d'une source de lumière de DEL selon la revendication 1, dans lequel une température de couleur et un indice de rendu des couleurs d'une émission de lumière sont régulés en ajustant des épaisseurs des premiers, des deuxièmes et des troisièmes motifs de phosphore.

4. Procédé d'encapsulation d'une source de lumière de DEL selon la revendication 1, dans lequel les puces de DEL (201) sont intégrées au substrat (200) par technologie eutectique, soudage de métal ou de liaison à fil.

5. Procédé d'encapsulation d'une source de lumière de DEL selon la revendication 4, dans lequel dans un cas où les puces de DEL (201) sont de structure horizontale, les puces de DEL sont intégrées au substrat au moyen d'une liaison à fil.

6. Procédé d'encapsulation d'une source de lumière de DEL selon la revendication 5, dans lequel le procédé comprend la formation d'un cordon métallique au niveau d'une borne positive de la puce de DEL (201) avec la structure horizontale ; et le câblage d'une borne négative au cordon métallique au niveau de la borne positive.

7. Procédé d'encapsulation d'une source de lumière de DEL selon la revendication 5, dans lequel le procédé comprend le câblage depuis une borne négative de la puce de DEL (201) avec la structure horizontale à une borne positive à connecter à la borne négative ; et la plantation d'un cordon métallique sur une surface de la borne positive après le câblage.

8. Procédé d'encapsulation d'une source de lumière de DEL selon la revendication 5, dans lequel le procédé comprend la formation d'un cordon métallique au niveau d'une borne positive de la puce de DEL (201) avec la structure horizontale ; le câblage depuis une borne négative au cordon métallique à la borne positive ; et la plantation d'un cordon métallique sur une surface de la borne positive après le câblage.

9. Procédé d'encapsulation d'une source de lumière de DEL selon la revendication 4, dans lequel les puces de DEL sont intégrées au substrat au moyen d'une technologie eutectique dans un cas où les puces de DEL sont de structure retournée.

10. Procédé d'encapsulation d'une source de lumière de DEL selon la revendication 7, dans lequel un fil de connexion formé par le câblage a une extrémité en forme de queue de poisson.

11. Structure d'encapsulation d'une source de lumière de DEL, comprenant :
un substrat (200) intégré avec des puces de DEL (201) ;
un porteur transparent (500) qui est en forme d'hémisphère creux disposé sur une surface du substrat (200), dans laquelle le porteur transparent (500) enveloppe les puces de DEL (201) pour former une cavité, et une surface du porteur transparent (500) est imprimée avec des motifs de phosphore (501), les motifs de phosphore comprennent un ou plusieurs premiers motifs de phosphore (511), un ou plusieurs deuxièmes motifs de phosphore (512) et un ou plusieurs troisièmes motifs de phosphore (513), dans laquelle la surface, sur laquelle sont imprimés les motifs de phosphore (501), du porteur transparent (500) fait face aux puces de DEL (201),
**caractérisée en ce que** :
les premiers, les deuxièmes et les troisièmes motifs de phosphore sont tous en forme d'hexagone régulier ou en forme de carré, deux quelconques des premiers, des deuxièmes et des troisièmes motifs de phosphore sont agencés adjacents l'un à l'autre, et des droites reliant des centres des premiers, des deuxièmes et des troisièmes motifs de phosphore forment un triangle équilatéral.

12. Structure d'encapsulation d'une source de lumière de DEL selon la revendication 11, dans laquelle le premier motif de phosphore (511) est un motif de phosphore rouge, jaune, vert ou vert jaunâtre, le deuxième motif de phosphore (512) est un motif de phosphore rouge, jaune, vert ou vert jaunâtre, et le troisième motif de phosphore (513) est un motif de phosphore rouge, jaune, vert ou vert jaunâtre.

13. Structure d'encapsulation d'une source de lumière de DEL selon la revendication 11, dans laquelle dans le cas où les puces de DEL sont intégrées au substrat au moyen d'un microcâblage, la structure d'encapsulation de la source de lumière de DEL comprend en outre un cordon métallique disposé au niveau d'une borne positive d'une première puce de DEL, et une liaison à fil connectant une borne négative d'une deuxième puce de DEL au cordon métallique au niveau de la borne positive de la première puce de DEL.

14. Structure d'encapsulation d'une source de lumière de DEL selon la revendication 11, dans laquelle dans un cas où les puces de DEL (201) sont intégrées au substrat (200) au moyen d'un microcâblage, la structure d'encapsulation de la source de lumière de DEL comprend en outre une liaison à fil connectant une borne positive d'une première puce de DEL (301) à une borne négative d'une deuxième puce de DEL (302), et un cordon métallique recouvrant le fil de câblage au niveau de la borne positive de la première puce de DEL (301).

15. Structure d'encapsulation d'une source de lumière de DEL selon la revendication 11, dans laquelle dans un cas où les puces de DEL (201) sont intégrées au substrat (200) au moyen d'une liaison à fil, la structure d'encapsulation de la source de lumière de DEL comprend en outre un cordon métallique disposé au niveau d'une borne positive d'une première puce de DEL (301), une liaison à fil connectant une borne négative d'une deuxième puce de DEL (302) au cordon métallique au niveau de la borne positive de la première puce de DEL (301), et un cordon métallique recouvrant la liaison à fil au niveau de la borne positive de la première puce de DEL (301).
